Europäisches Patentamt

European Patent Office

Office européen des brevets

(11) Publication number: **0 587 945 A1**

# EUROPEAN PATENT APPLICATION

(21) Application number: **92202870.9**

(22) Date of filing: **18.09.92**

(51) Int. Cl.5: **H03F 3/217**, H03F 3/30

(43) Date of publication of application:
**23.03.94 Bulletin 94/12**

(84) Designated Contracting States:
**AT BE CH DE DK ES FR GB GR IE IT LI LU MC NL PT SE**

(71) Applicant: **MIETEC ALCATEL**
**Westerrring 15**
**B-9700 Oudenaarde(BE)**
Applicant: **Alcatel N.V.**
**De Lairessestraat 153**
**NL-1075 HK Amsterdam(NL)**

(72) Inventor: **Op T Eynde, Frank Nico Lieven**
**Straetmanshof 11**
**B-3012 Wilsele-Leuven(BE)**
Inventor: **Vandensande, Geert Maria Marcel**
**Houwstraat 102**
**B-2580 Beerzel (Putte)(BE)**

(74) Representative: **Vermeersch, Robert**
**BELL TELEPHONE MANUFACTURING**
**COMPANY**
**Naamloze Vennootschap**
**Patent Department**
**Francis Wellesplein 1**
**B-2018 Antwerpen (BE)**

(54) **Amplitude regulation circuit.**

(57) An amplitude regulation circuit (REG) is presented which regulates towards a reference amplitude (VR) an amplitude of a pulse waveform which is generated across a load impedance (L) by a so-called H-bridge, at least one of whose switches has a variable impedance. The amplitude regulation circuit (REG) includes a measuring means (C1) measuring said amplitude during first parts of said pulse waveform and a regulating means (OA, C2, CS1, S2, S3, Q5, CS2, S4, S5, Q6) which is controlled by said measuring means (C1) during second parts of said pulse waveform and which regulates said variable impedance, thereby regulating said pulse waveform amplitude.

FIG.1

The present invention relates to an amplitude regulation circuit.

If such a circuit would be used to regulate an amplitude of a pulse waveform generated by e.g. a so-called H-bridge across a load impedance, it could be designed as a negative feedback circuit continuously measuring the pulse waveform amplitude, comparing it with a desired or reference amplitude, and providing a correction value for the measured amplitude. Thereby the amplitude of the pulse waveform would be continuously adjusted towards the reference amplitude and a continuous negative feedback loop would exist. Depending on the nature of the load impedance cooperating with parasitic elements, such a negative feedback loop could give rise to oscillations, especially with an inductive load impedance and, when use is made of a H-bridge, due to parasitic capacitances being then introduced by switches of this bridge.

An object of the present invention is therefore to provide an amplitude regulation circuit for regulating the amplitude of an electric value in a load impedance.

According to the invention, this object is achieved due to the fact that said amplitude regulation circuit regulates towards a reference amplitude an amplitude of a pulse waveform which is generated across a load impedance by alternately branching said load impedance across the poles of a DC source in series with first and second switching means, respectively, at least one of which has a variable impedance, so as to allow current flow through said load impedance in a first and a second opposite directions respectively, and that said amplitude regulation circuit includes a measuring means measuring said amplitude during first parts of said pulse waveform and a regulating means which is controlled by said measuring means during second parts of said pulse waveform and which regulates said variable impedance, thereby regulating said pulse waveform amplitude.

Thus the amplitude regulation circuit includes a negative feedback loop wherein the pulse waveform amplitude is measured by the measuring means and then processed by the regulating means and wherein the result thus obtained regulates the variable impedance and thereby the pulse waveform amplitude. However, since the measuring means only measures the amplitude during the first parts of the pulse waveform and only controls the regulating means during the second parts thereof, the loop is not continuously closed so that the load impedance and the parasitic elements cannot be the source of oscillations.

Another characteristic of the present amplitude regulation circuit is that said measuring means includes a capacitor and switching means to branch said capacitor across said load impedance during said first part, thereby measuring said amplitude, and to branch it across an input of said regulating means during said second part thereby controlling said regulating means.

This provides an easy way of measuring the amplitude.

To be noted that in case one would use a continuous feedback loop with an inductive load impedance of the type referred to above, the capacitor would strongly complicate the problem of avoiding oscillations because of the LC resonant filter which is then formed by the load impedance and the capacitor. Due to the feedback operation being performed in two steps, as in the invention, this problem no longer exists.

A further characteristic of the present amplitude regulation circuit is that said capacitor is never simultaneously branched across said load impedance and across said regulating means input.

In this way the feedback loop is never completely closed and the regulating means is never directly controlled by the load impedance so decreasing the risk for oscillations.

Still another characteristic of the present amplitude regulation circuit is that said regulating means includes a summing circuit adding during said second part the difference between said measured amplitude and said reference amplitude to a previously held sum, and temporarily holding the thus obtained new sum.

The summing circuit thus keeps track of the summed difference and adapts it at each second part.

Yet a further characteristic of the present amplitude regulation circuit is that said variable impedance switching means includes a voltage controlled device, and that said regulating means further includes a pulse voltage generating means for driving said voltage controlled device and to a voltage amplitude control input of which said summed difference is applied.

The pulse voltage generating means generates a driving pulse voltage for the variable impedance voltage controlled device thereby assisting in producing the pulse waveform across the load impedance, the amplitude of which is controlled by controlling the driving pulse voltage amplitude via the voltage amplitude control input of the pulse voltage generating means.

Another feature of the present amplitude regulation circuit is that said pulse voltage generating means includes the cascaded connection of a current source means and a switch connected in parallel with a voltage controlled resistor a control input of which constitutes said voltage amplitude control input, and the connection node of said switch and said current source means driving said voltage controlled device.

Thus the driving pulse voltage amplitude is determined by the current provided by the current source means and the resistance of the voltage controlled resistor.

A further feature of the present amplitude regulation circuit is that said current source means is constituted by the series connection of a current source and a switch.

In this way current provided by the current source can be cut off when the voltage controlled device voltage amplitude control input is not to be driven by the current source.

Still a further characteristic feature of the present amplitude regulation circuit is that said summing circuit is constituted by an operational amplifier an output and an inverting input of which are interconnected via a negative feedback capacitor, said output providing said summed difference, said inverting input constituting said regulating means input, and said reference amplitude being applied to a non-inverting input of said operational amplifier.

The above mentioned and other objects and features of the present amplitude regulation circuit will become more apparent and the invention itself will be best understood by referring to the following description of an embodiment taken in conjunction with the accompanying drawings wherein :

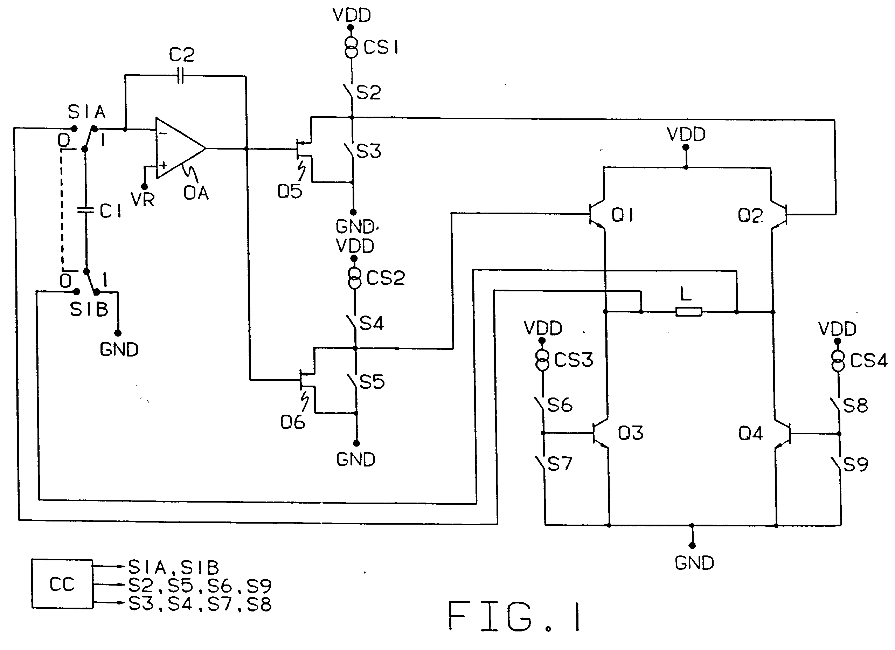

Fig. 1 shows an amplitude regulation circuit REG according to the invention and used for controlling an amplitude of a pulse waveform generated by a so-called H-bridge Q1/Q2/Q3/Q4; and

Fig. 2 represents waveforms appearing in the circuit of Fig. 1.

The amplitude regulation circuit REG regulates the amplitude of the pulse waveform generated across a load impedance L by a so-called H-bridge Q1/Q2/Q3/Q4. This H-bridge Q1/Q2/Q3/Q4 is constituted by the parallel connection, between a positive pole VDD and a ground pole GND of a DC source, of two branches Q1/Q3 and Q2/Q4 each consisting of the cascaded connection of two switches constituted by bipolar npn transistors Q1, Q2, Q3, Q4. Each of these transistors is driven by a pulse voltage generator which is constituted by the cascaded connection, between VDD and GND, of a current source and a pair of switches viz. CS2/S4/S5 for Q1, CS1/S2/S3 for Q2, CS3/S6/S7 for Q3, and CS4/S8/S9 for Q4. The connecting node of each pair of switches drives the base of the corresponding H-bridge transistor. The switches are driven by a clock circuit CC, as will be described further. The current sources are e.g. built from (not shown) transistors. To be noted that switches S2, S4, S6 and S8 which in combination with the current sources CS1, CS2, CS3 and CS4, respectively, represent respective current source means, can be left out, i.e. they then are a short circuit all the time, in which case the respective current sources also provide a current when this is not needed to drive Q1, Q2, Q3 and Q4.

The load impedance L is connected in parallel with a measuring means consisting of the cascaded connection of a switch S1a, a capacitor C1 and a switch S1b. S1a and S1b are so-called change-over switches which can e.g. be built from a (not shown) parallel connection of two transistors. These switches S1a and S1b which are also driven by the clock circuit CC, have a position 0 in which case C1 is connected in parallel with the load impedance L and a position 1 in which case C1 is branched across an input -/GND of a summing means. This summing means is constituted by an operational amplifier OA a non-inverting input + of which is connected to a DC source supplying a reference voltage or amplitude VR with respect to GND. An output of OA is coupled to an inverting input - of OA via a negative feedback capacitor C2, and the inverting input - constitutes one of the summing means input poles -/GND over which C1 can be branched. The output of OA drives the gate of a transistor Q5 and of a transistor Q6, which both are p-channel FET's. The drain-source path of Q5 is branched between GND and the connection node of S2 and S3, which in its turn drives the base of transistor Q2. Similarly, the drain-source path of Q6 is branched between GND and the connection node of S4 and S5 which in its turn drives the base of transistor Q1. To be noted that Q5 and Q6 can also be constituted by pnp bipolar transistors.

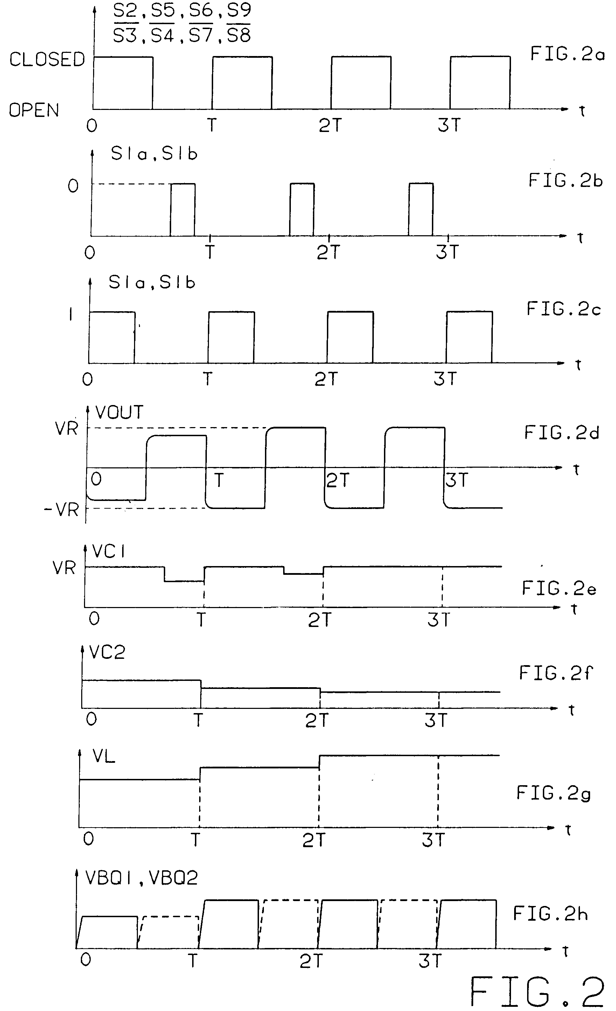

The operation of the amplitude regulation circuit REG and the generation of the pulse waveform across the load impedance L is now described hereinafter with reference to the waveforms shown in Fig. 2a-h and appearing at various points in the circuit.

The waveform shown in Fig. 2a is provided by the clock circuit CC and represents the periodic on and off switching of switches S2, S5, S6 and S9 which is complementary with the on and off switching of switches S3, S4, S7 and S8. It is to be noted that for driving the switches S2 to S9 use should be made of at least two non-overlapping clocks since switches Q1 and Q3, as well as Q2 and Q4 may never be closed at the same instant as this would cause a short circuit of VDD to GND. However, since this is not a subject of the present amplitude regulation circuit the clocks will be assumed to be complementary. On the contrary if e.g. S2 and S3 were closed at the same instant this would not be a problem as this only causes the current provided by current source CS1 to still flow, then in S3, when no longer necessary.

Abstraction being made of the amplitude regulation circuit REG, when S2, S5, S6 and S9 are open and as a consequence S3, S4, S7 and S8 are closed then a current provided by CS2 and CS4 flows into the bases of Q1 and Q4, respectively, and the voltages at the bases of Q2 and Q3 are pulled to GND thereby closing switches Q1 and Q4 and opening switches Q2 and Q3, i.e. Q1 and Q4 are conducting and Q2 and Q3 are non-conducting. Hence, a current flows through the load impedance L in a first direction building up

3

a voltage VOUT over L in a first sense as shown in Fig. 2d (VR) the particularities of which are treated hereinafter. When on the other hand S2, S5, S6 and S9 are closed and S3, S4, S7 and S8 are open then switches Q1 and Q4 are open and switches Q2 and Q3 are closed, i.e. Q2 and Q3 are conducting and Q1 and Q4 are non-conducting thereby allowing a current to flow through L in a second direction and the voltage VOUT to be built up over L in a second sense as also shown in Fig. 2d (-VR).

The pulse waveform which is thus generated across the load impedance L is periodically measured or sampled by C1 during a first value part of the pulse waveform as indicated by Fig. 2b which shows when switches S1a and S1b are in the position 0. These switches are only in this position when the voltage VOUT across L is stabilized, as will become, clear later, and thus the latter voltage VOUT also appears across C1. This voltage VC1 across C1 which is shown in Fig. 2e is built up almost immediately as only the series resistances of S1a and S1b which are supposed to be small, slow it down. To be noted that C1 is supposed to be small enough so as not to influence this voltage VOUT. The signals driving S1a and S1b are produced by the clock circuit CC.

The sampled or measured value VMEAS of the voltage across L is then applied across the input -/GND of OA during a second part of the pulse waveform as indicated by Fig. 2c which shows when switches S1a and S1b are in the position 1. To be noted that the waveforms driving S1a and S1b and shown in Fig. 2b and Fig. 2c represent non-overlapping clocks. If this would not be the case L would during some time be branched directly across the input -/GND of OA. Consequently, C2 would then be connected between two low impedance points of the circuit, viz. the output of OA and one side of L. Thereby the charge on C2 would almost instantly be changed so eliminating the effect of previous regulation and giving an enlarged risk for oscillations.

When applied to the input -/GND, the measured value or amplitude VMEAS is compared with a reference amplitude VR. When the measured amplitude is lower than VR then an amount of charges representing the difference thereof flows from C2 to C1 thereby causing the voltage VC1 over C1 to rise to VR. Thus the charge on C2 being diminished with an amount (VMEAS - VR)*C1 the voltage VC2 over C2 shown in Fig. 2f decreases with an amount (VMEAS - VR)*C1/C2 and consequently the voltage VL at the output of OA which is shown in Fig. 2g increases with the same amount. When C1 is uncoupled from the input of OA, the voltage at its output remains substantially constant since the non-inverting input of OA is kept at VR and since the charge on C2 and hence the voltage VC2 can then not change. This is shown in Fig. 2f and Fig. 2g. The transition of the output of OA from a state before connecting C1 to a new stable state after connecting C1 is substantially immediate since only the series resistances of S1a and S1b which are supposed to be small, delay this transition.

The voltage at the output of OA is applied to transistors Q5 and Q6 which constitute voltage controlled resistors over which the current provided by CS1 and CS2, respectively, builds up a voltage when switch S2 is closed and S3 is open, or S4 is closed and S5 is open, respectively. Hence the output voltage VL of OA determines the resistance of the source-drain path of Q5 and Q6 and thereby the driving voltage of the bases of Q2 and Q1 and thus the voltage drop across the collector-emitter path of the latter two transistors. In this way the voltage appearing across the load impedance L is regulated. The driving voltages VBQ1 and VBQ2 of the base of Q1 and Q2, respectively, are shown in Fig. 2h.

As transistors Q5 and Q6 are used as so-called source-followers a change of their gate voltage causes an almost equal change of their source voltage. Similarly since Q1 and Q2 are used as so-called emitter-followers a change of their base voltage causes an almost equal emitter voltage change. Hence the transfer factor $\alpha$ from the voltage at the output of OA to the voltage across L is substantially equal to 1.

When $VMEAS_k$ indicates the measured amplitude across L at a k-th pulse switching S1a and S1b to its position 0 then an equation describing the behaviour of the amplitude regulation circuit REG can be written as follows :

$$VMEAS_k = VMEAS_{k-1} - \alpha * (VMEAS_{k-1} - VR) * \frac{C1}{C2} \qquad (1)$$

This equation can be solved and has as a solution :

$$VMEAS_k = VR + (1 - \alpha * \frac{C1}{C2})^k * (VMEAS_0 - VR) \qquad (2)$$

Hence when the factor

$$1 - \alpha * \frac{C1}{C2}$$

is strictly greater than -1 and strictly smaller than +1 the second term of the sum in equation (2) decreases with each pulse switching S1a and S1b to position 0, and thus VMEAS tends towards VR. Otherwise the second term in equation (2) increases with each pulse and the circuit is unstable. Since $\alpha$ is substantially equal to 1 as explained above, this means that the value of C1/C2 has to be between 0 and 2 in order for the circuit to be stable. Moreover if C1/C2 equals 1 the system stabilizes in one step as can be seen from equation (2) where k as well as a equal 1 and where C1 equals C2 :

$$VMEAS_1 = VR + (1 - \alpha * \frac{C1}{C2}) * (VMEAS_0 - VR) = VR \qquad\qquad (3)$$

Thus, although $\alpha$ is not exactly known, oscillations can be easily avoided by choosing C1 substantially equal to C2. When equation (3) is not completely satisfied the pulse waveform amplitude of the voltage VOUT across the load L is regulated towards VR independently of the voltage drops over the switches Q1 to Q4, in successive steps each comprising a period T and being understood from the above description. This is shown in Fig. 2a-h.

It is to be noted that the reference amplitude VR can be slowly varying in which case the amplitude of the pulse waveform appearing across the load L being adjusted towards VR follows this slowly varying amplitude. In this way an AM-modulator modulating a pulse waveform with VR is obtained. In order to better follow the changes of VR the switches S1a and S1b may then e.g. be given a higher switching frequency thereby providing multiple measuring and adjusting operations within one period of the pulse waveform across L. In this case one should take care that the measuring operation is only performed during one and the same value of the pulse waveform across L, i.e. either during the positive (VR) or the negative value (-VR), or that C1 is reversely branched across L when measuring during opposite values which can easily be done by replacing S1a and S1b by a so-called three position switch having three positions viz. a position 0 where C1 is branched across L in one sense, a position 1 where C1 is branched across L in the opposite sense and a position 2 where C1 is branched across the operational amplifier input. The choice of position 0 or 1 which is made in the clock circuit CC then depends upon whether the pulse waveform across L has a positive or negative value which can be deduced from the setting of switches S2 to S9.

The above mentioned example of a H-bridge with two branches (Q1/Q3 and Q2/Q4) can be generalized to e.g. a H-bridge with three branches in which case three load impedances can be considered. One could then e.g. measure the amplitude over one of these load impedances and then adjust the amplitude over all three impedances, or one could measure and adjust the amplitude alternately over the three impedances, or one could even measure the amplitude over all three impedances and then determine an average of the three measured amplitudes before adjusting the amplitude over all three impedances. In this last case the measuring or sampling frequency is imperatively higher than the frequency of the pulse waveform across L.

While the principles of the present amplitude regulation circuit have been described above in connection with specific apparatus, it is to be clearly understood that this description is made only by way of example and not as a limitation on the scope of the present invention.

## Claims

1. Amplitude regulation circuit (REG), characterized in that it regulates towards a reference amplitude (VR) an amplitude of a pulse waveform which is generated across a load impedance (L) by alternately branching said load impedance (L) across the poles of a DC source (VDD, GND) in series with first (Q1, Q4) and second (Q2, Q3) switching means, respectively, at least one of which has a variable impedance, so as to allow current flow through said load impedance (L) in a first and a second opposite directions respectively, and that said amplitude regulation circuit (REG) includes a measuring means (C1) measuring said amplitude during first parts of said pulse waveform and a regulating means (OA, C2, CS1, S2, S3, Q5, CS2, S4, S5, Q6) which is controlled by said measuring means (C1) during second parts of said pulse waveform and which regulates said variable impedance, thereby regulating said pulse waveform amplitude.

2. Amplitude regulation circuit (REG) according to claim 1, characterized in that said measuring means (C1) includes a capacitor (C1) and switching means (S1a, S1b) to branch said capacitor (C1) across said load impedance (L) during said first part, thereby measuring said amplitude, and to branch it across an input (-, GND) of said regulating means (OA, C2, CS1, S2, S3, Q5, CS2, S4, S5, Q6) during said second part thereby controlling said regulating means (OA, C2, CS1, S2, S3, Q5, CS2, S4, S5, Q6).

3. Amplitude regulation circuit (REG) according to claim 2, characterized in that said capacitor (C1) is never simultaneously branched across said load impedance (L) and across said regulating means input (-,GND).

4. Amplitude regulation circuit (REG) according to claim 1, characterized in that said regulating means (OA, C2, CS1, S2, S3, Q5, CS2, S4, S5, Q6) includes a summing circuit (OA, C2) adding, during said second part, the difference between said measured amplitude and said reference amplitude (VR) to a previously held sum and temporarily holding the thus obtained new sum.

5. Amplitude regulation circuit (REG) according to claim 4, characterized in that said variable impedance switching means (Q1, Q4/ Q2, Q3) includes a voltage controlled device (Q1/ Q2), and that said regulating means (OA, C2, CS1, S2, S3, Q5, CS2, S4, S5, Q6) further includes a pulse voltage generating means (CS1, S2, S3, Q5/ CS2, S4, S5, Q6) for driving said voltage controlled device (Q1/ Q2) and to a voltage amplitude control input of which said summed difference is applied.

6. Amplitude regulation circuit (REG) according to claim 5, characterized in that said voltage controlled device (Q1/ Q2) is constituted by a transistor.

7. Amplitude regulation circuit (REG) according to claim 5, characterized in that said pulse voltage generating means (CS1, S2, S3, Q5/ CS2, S4, S5, Q6) includes the cascaded connection of a current source means (CS1, S2/ CS2, S4) and a switch (S3/ S5) connected in parallel with a voltage controlled resistor (Q5/ Q6) a control input of which constitutes said voltage amplitude control input, and the connection node of said switch (S3/ S5) and said current source means (CS1, S2/ CS2, S4) driving said voltage controlled device (Q1/ Q2).

8. Amplitude regulation circuit (REG) according to claim 7, characterized in that said current source means (CS1, S2/ CS2, S4) is constituted by the series connection of a current source (CS1/ CS2) and a switch (S2/ S4).

9. Amplitude regulation circuit (REG) according to claims 2 and 4, characterized in that said summing circuit (OA, C2) is constituted by an operational amplifier (OA) an output and an inverting input of which are interconnected via a negative feedback capacitor (C2), said output providing said summed difference, said inverting input constituting said regulating means (OA, C2, CS1, S2, S3, Q5, CS2, S4, S5, Q6) input, and said reference amplitude (VR) being applied to a non-inverting input of said operational amplifier (OA).

10. Amplitude regulation circuit (REG) according to any of the previous claims, characterized in that said amplitude regulation circuit (REG) is implemented as an integrated circuit.

11. Method for regulating an amplitude, characterized in that it is used for regulating towards a reference amplitude (VR) an amplitude of a pulse waveform which is generated across a load impedance (L) by alternately branching said load impedance (L) across the poles of a DC source (VDD, GND) in series alternately with first (Q1, Q4) and second (Q2, Q3) variable impedance switching means, respectively, so as to allow current flow through said load impedance (L) in a first and a second opposite directions respectively, said method including the step of regulating said amplitude via a feedback loop, and the additional step of sensing said amplitude during first parts of said pulse waveform, said regulating step only being executed during second parts of said pulse waveform.

FIG. I

EP 0 587 945 A1

FIG.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-5 107 190 (WARREN I. SCHULTZ ET AL.)<br><br>* column 2, line 62 - column 3, line 56; figures 5-7,9 * | 1-3,5,6,11 | H03F3/217<br>H03F3/30 |
| A | GB-A-2 070 371 (MATSUSHITA ELECTRIC INDUSTRIAL CO.)<br>* page 2, line 4 - page 3, line 7; figure 4 * | 1,11 | |
| A | PATENT ABSTRACTS OF JAPAN<br>vol. 12, no. 111 (E-598)8 April 1988<br>& JP-A-62 239 869 ( HITACHI )<br>* abstract * | 1,10 | |
| A | ELEKTOR<br>vol. 9, no. 7, August 1983,<br>page 7-36 'Car PDM amplifier'<br>* the whole document * | 1,11 | |

TECHNICAL FIELDS
SEARCHED (Int. Cl.5 )

H03F
G05F
H02P

The present search report has been drawn up for all claims

| Place of search | Date of completion of the search | Examiner |
|---|---|---|
| THE HAGUE | 19 MAY 1993 | WALDORFF U. |